# FASCICULE DE BREVET EUROPEEN

(11) **EP 1 903 615 B1**
(45) Date de publication et mention de la délivrance du brevet: **11.11.2009**
(21) Numéro de dépôt: 07116751.4
(22) Date de dépôt: 19.09.2007
(51) Int. Cl.: H01L 31/18, H01L 31/0224

(54) **Procédé de métallisation de cellules photovoltaïques à multiples recuits**
Verfahren zur Metallisierung mehrfach wärmebehandelter photovoltaischer Solarzellen
Metallisation method for multiply annealed photovoltaic cells

(30) Priorité: 21.09.2006 FR 0653884
(43) Date de publication de la demande: 26.03.2008
(73) Titulaire: COMMISSARIAT A L'ENERGIE ATOMIQUE, 75015 Paris (FR)
(72) Inventeur: Ribeyron, Pierre Jean, 38330, Saint Ismier (FR); Dubois, Sébastien, 38000, Grenoble (FR); Enjalbert, Nicolas, 38630, Les Avenirs (FR)
(74) Mandataire: Poulin, Gérard

(56) Documents cités:
- US-A- 4 577 393
- US-A1- 2005 189 015
- NIJS J F ET AL: "Advanced Manufacturing Concepts for Crystalline Silicon Solar Cells" IEEE TRANSACTIONS ON ELECTRON DEVICES, IEEE SERVICE CENTER, PISACATAWAY, NJ, US, vol. 46, no. 10, octobre 1999 (1999-10), pages 1948-1969, XP011017056 ISSN: 0018-9383
- SANA P ET AL: "The effect of aluminum treatment and forming gas anneal on EFG silicon solar cells" PROCEEDINGS OF THE PHOTOVOLTAIC SPECIALISTS CONFERENCE. LOUISVILLE, MAY 10 - 14, 1993, NEW YORK, IEEE, US, vol. CONF. 23, 10 mai 1993 (1993-05-10), pages 111-116, XP010113294 ISBN: 0-7803-1220-1
- OKAMOTO S ET AL: "23.5% efficient silicon solar cell with rear micro contacts of c-Si spl mu/c-Si:H heterostructure" CONFERENCE RECORD OF THE 26TH IEEE PHOTOVOLTAIC SPECIALISTS CONFERENCE, 29 septembre 1997 (1997-09-29), pages 255-258, XP010267775 ISBN: 0-7803-3767-0

## Description

### DOMAINE TECHNIQUE ET ART ANTÉRIEUR

L'invention concerne le domaine des cellules photovoltaïques et plus particulièrement un procédé de métallisation de cellules photovoltaïques.

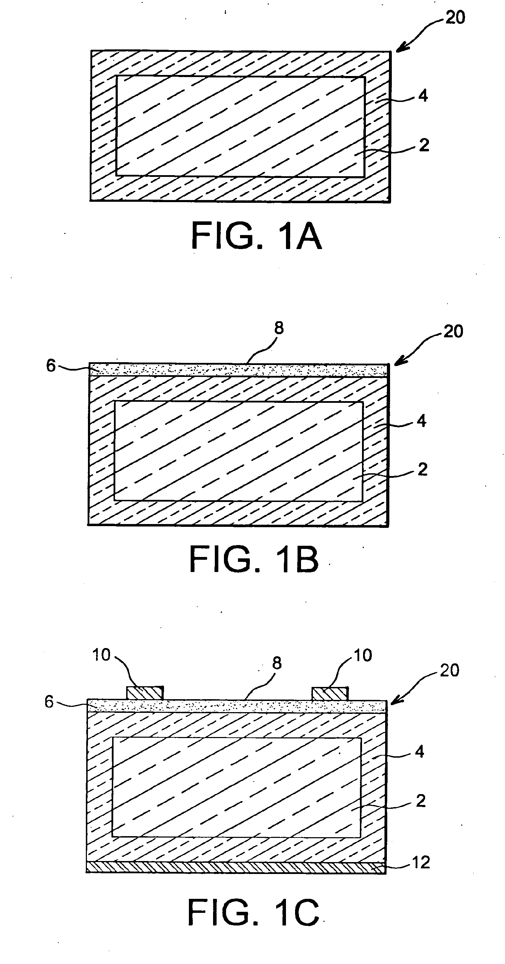

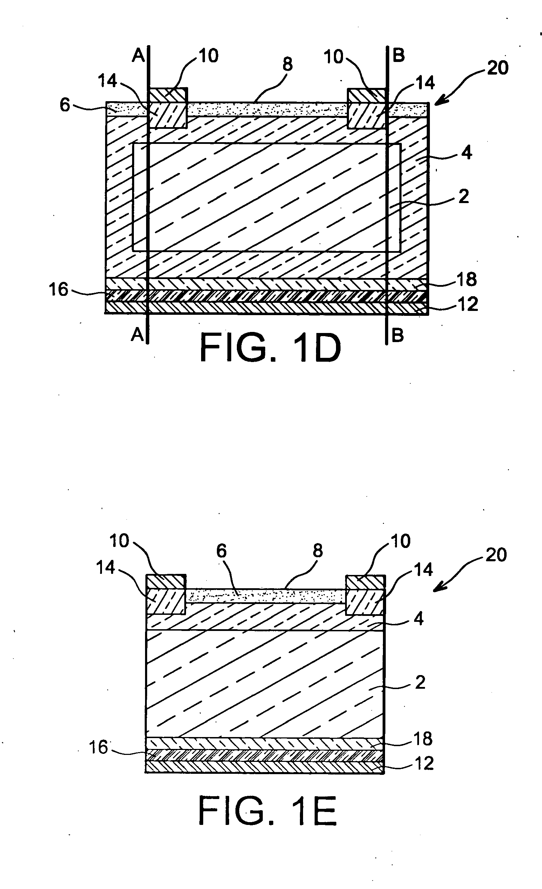

Un procédé standard utilisé pour la production industrielle d'une cellule photovoltaïque 20 à base de silicium cristallin (monocristallin ou multicristallin) de type P ou N est représenté sur les figures 1A à 1E. Un substrat 2 de type N ou P subi tout d'abord une texturation de ses surfaces par l'utilisation d'une solution d'hydroxyde de potassium, permettant de réduire la réflectivité de ces surfaces et ainsi d'obtenir un meilleur confinement optique des faisceaux entrants dans le substrat 2. Une couche 4 de type N+ est formée dans le substrat 2 par diffusion de phosphore au niveau de toutes les faces du substrat 2 (figure 1A). Une couche antireflet 6 de nitrure de silicium riche en hydrogène (*SiN* - *H*) est ensuite déposée sur la couche N+ 4 par dépôt chimique en phase vapeur assisté par plasma (PECVD), comme représenté sur la figure 1B, formant une face avant 8 de la cellule photovoltaïque 20. Des métallisations en argent 10 et en aluminium 12 sont formées par sérigraphie respectivement sur la face avant 8 et sur la face arrière du substrat 2 (figure 1C). Enfin, ces métallisations 10, 12 subissent un recuit dans un four à passage infrarouge, formant des contacts 14 entre les métallisations avant 10 et la couche N+ 4, ainsi qu'une couche 16 à base d'un alliage d'aluminium et de silicium, et une couche 18 de type P+ dans le substrat 2, venant remplacer une partie de la couche N+ 4 sous la métallisation arrière 12.

Enfin, comme représenté sur la figure 1E, on supprime les portions de la couche N+ 4 reliant la couche 18 aux contacts 14, c'est-à-dire reliant électriquement les métallisations 10 de la face avant à la couche de métallisation 12 de la face arrière. Sur la figure 1E, tous les éléments de la cellule photovoltaïque 20 se trouvant du côté extérieur des plans AA et BB sont supprimés, par exemple par laser, plasma, enrobage ou tout autre moyen de gravure.

Dans le cas d'un substrat 2 de type P, la partie de la couche N+ 4 restante et le substrat 2 forment la jonction PN de la cellule photovoltaïque 20. La couche P+ 18 permet la passivation de la face arrière du substrat 2 par un effet de champ arrière (BSF) repoussant des porteurs minoritaires, ici des électrons, dans le substrat 2. Dans le cas d'un substrat 2 de type N, c'est la couche P+ 18 et le substrat 2 qui forment la jonction PN de la cellule photovoltaïque 20, et la couche N+ 4 réalise la passivation de la face avant du substrat 2 par un effet de champ avant (FSF) repoussant des porteurs minoritaires, ici des trous, dans le substrat 2, la couche antireflet 6 contribuant également à cette passivation. Le document « N-type multicrystalline silicon for solar cells » de S. Martinuzzi et al, 20th EPSEC, 2005, Barcelone, pages 631 à 634, décrit une telle cellule photovoltaïque, la température de recuit décrite étant comprise entre 850°C et 900°C.

Lors du recuit, de l'hydrogène migre sous forme d'ions à partir de la couche antireflet 6 riche en hydrogène sur quelques micromètres avant de former de l'hydrogène moléculaire *H*₂ dont la diffusion est limitée dans le silicium du substrat 2 et qui n'a pas la propriété, comme les ions hydrogène, de passiver les défauts cristallographiques et les impuretés. Or, lors de la formation de la couche en alliage 16, des lacunes migrent dans le substrat 2 et permettent la dissociation des molécules *H*₂*,* permettant aux ions hydrogène de diffuser beaucoup plus profondément dans le substrat 2, améliorant la durée de vie des porteurs dans le substrat 2 et donc, améliorant également le rendement de conversion de la cellule photovoltaïque 20. De plus, cette couche en alliage 16 permet d'améliorer la qualité du silicium du substrat 2 par effet getter en piégeant les impuretés par un mécanisme de ségrégation. Ce phénomène d'hydrogénation lors du recuit est décrit dans le document « Hydrogen passivation of defects in multicrystalline silicon solar cells » de S. Martinuzzi et al, Solar Energy Materials & Solar Cells, vol. 80, pages 343 à 353, 2003.

La diffusion de l'hydrogène dans le substrat 2 est particulièrement efficace lorsque les densités de défauts cristallographiques étendus, tels que des dislocations ou des joints de macle, sont importantes. La passivation par l'hydrogène est très utile lorsque les concentrations d'impuretés, principalement métalliques, sont importantes, par exemple dans les matériaux élaborés à partir de charges de mauvaise qualité (charges de silicium métallurgique), ou les matériaux riches en dislocations comme ceux issus de coulées continues électromagnétiques ou de tirages en ruban.

Le document US 4,577,393 décrit un procédé de métallisation d'au moins une cellule photovoltaïque.

Le document « Ribbon Si solar cells with efficiencies over 18 % by hydrogenation of defects », de D.S. Kim et al., Solar Energy Materials & Solar Cells, vol. 90, pages 1227 à 1240, 2006, décrit un recuit de la face arrière d'une cellule photovoltaïque à une température comprise entre 700°C et 800°C dans un four de type RTP (rapid thermal processing en anglais, ou à traitement thermique rapide). Dans l'exemple décrit, les métallisations en face avant sont réalisées par photolithographie et gravure d'une couche antireflet, et évaporation de titane, palladium et argent. La cellule obtenue offre un rendement légèrement supérieur à 18% avec un substrat multicristallin de silicium de type P obtenu par tirage en rubans mais le procédé proposé n'est économiquement pas viable et difficilement transférable dans l'industrie.

### EXPOSÉ DE L'INVENTION

Un but de la présente invention est de proposer un procédé de métallisation de cellules photovoltaïques permettant d'obtenir des cellules photovoltaïques ayant un meilleur rendement que les cellules réalisées selon les procédés de l'art antérieur décrits précédemment, et qui soit économiquement viable dans l'industrie.

Pour cela, la présente invention propose un procédé de métallisation d'au moins une cellule photovoltaïque comportant un substrat à base de semi-conducteur d'un premier type de conductivité, une couche dopée d'un second type de conductivité réalisée dans le substrat et formant une face avant du substrat, une couche antireflet réalisée sur la face avant du substrat et formant une face avant de la cellule photovoltaïque, ledit procédé comportant au moins les étapes de :
a) réalisation d'au moins une métallisation sur la face avant de la cellule photovoltaïque,
b) premier recuit de la cellule photovoltaïque à une température comprise entre environ 800°C et 900°C,
c) réalisation d'au moins une métallisation sur la face arrière du substrat,
d) second recuit de la cellule photovoltaïque à une température comprise entre environ 700°C et 800°C.

Ainsi, on obtient une meilleure passivation des impuretés et défauts cristallographiques dans le substrat de la cellule photovoltaïque durant la réalisation des métallisations de la cellule photovoltaïque selon le procédé objet de la présente invention qu'avec les procédés de métallisation de l'art antérieur. Ce procédé est donc particulièrement adapté à la réalisation de cellules photovoltaïques comportant des substrats obtenus à partir de charges de moindre qualité et de matériaux riches en dislocations, par exemple du silicium issu d'une coulée continue électromagnétique et d'un tirage en ruban.

Le procédé s'applique aussi bien pour des substrats de type N que de type P.

La présente invention concerne également un procédé de réalisation d'au moins une cellule photovoltaïque, comportant au moins les étapes de :
- texturation des surfaces d'un substrat à base de semi-conducteur d'un premier type de conductivité,
- formation d'une couche dopée d'un second type de conductivité dans le substrat formant une face avant du substrat,
- dépôt d'une couche antireflet sur la face avant du substrat, ladite couche formant une face avant de la cellule photovoltaïque,
- mise en oeuvre d'un procédé de métallisation tel que décrit précédemment, également objet de la présente invention,
- suppression d'au moins une partie de la couche dopée du second type de conductivité reliant électriquement la métallisation de la face avant à la métallisation de la face arrière de la cellule photovoltaïque.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels:
- les figures 1A à 1E déjà décrites représentent les étapes d'un procédé de réalisation d'une cellule photovoltaïque selon l'art antérieur,
- les figures 2A à 2E représentent les étapes d'un procédé de réalisation d'une cellule photovoltaïque, objet de la présente invention, comportant des métallisations réalisées selon un procédé également objet de la présente invention.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

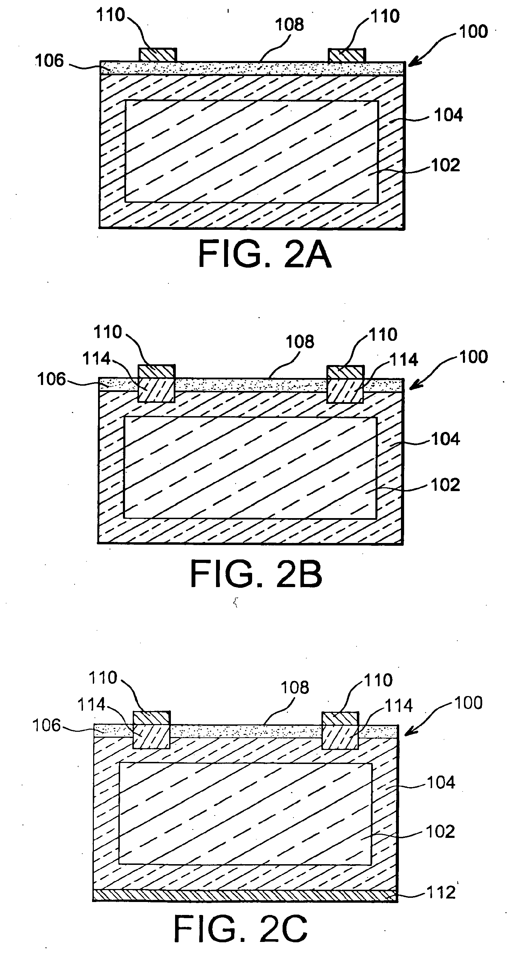

On se réfère aux figures 2A à 2E représentant les étapes d'un procédé de réalisation d'une cellule photovoltaïque 100. Un procédé de métallisation de cellule photovoltaïque 100 sera également décrit en liaison avec ces figures.

Un substrat 102 d'un premier type de conductivité, par exemple à base de silicium multicristallin ou monocristallin de type P, est représenté sur la figure 2A. Pour la réalisation de la cellule photovoltaïque 100, on réalise tout d'abord une texturation des surfaces du substrat 102 par l'utilisation d'une solution d'hydroxyde de potassium. Une couche 104 dopée d'un second type de conductivité, par exemple de type N+, est ensuite formée par diffusion de phosphore dans le substrat 102. Cette couche 104 forme notamment une face avant du substrat 102 sur laquelle est déposée, par exemple par PECVD, une couche antireflet 106, par exemple riche en hydrogène et à base de nitrure de silicium ou de carbure de silicium, et formant une face avant 108 de la cellule photovoltaïque 100. La jonction PN de la cellule photovoltaïque 100 est formée par le substrat 102 de type P et la couche N+ 104.

Une étape d'hydrogénation du substrat 102, par exemple par plasma, peut être mise en oeuvre durant le procédé. Cette étape peut être réalisée par exemple avant et/ou après le dépôt de la couche antireflet 106.

Le procédé de métallisation de la cellule photovoltaïque 100 va maintenant être décrit. Comme représenté sur la figure 2A, des métallisations 110, par exemple à base d'argent, sont réalisées par exemple par sérigraphie sur la face avant 108 de la cellule photovoltaïque 100. Les métallisations 110 peuvent également être à base d'au moins un autre métal que l'argent, et formées par d'autres techniques telles que la photolithographie ou l'impression.

La cellule solaire 100 est ensuite placée par exemple dans un four à passage infrarouge pour subir un premier recuit. Ce premier recuit est réalisé à une température comprise entre environ 800°C et 900°C, formant ainsi des contacts 114 entre les métallisations 110 et la couche N+ 104 (figure 2B). Lors de ce premier recuit, de l'hydrogène migre sous forme d'ions à partir de la couche antireflet 106 riche en hydrogène dans le substrat 102, réalisant une passivation des défauts cristallographiques et des impuretés du substrat 102. Ce premier recuit peut également être réalisé dans un four de recuit classique, ou par d'autres techniques de recuit connues. Par exemple, ce premier recuit est réalisé à une température égale à environ 850°C, pendant une durée comprise entre environ 1 seconde et 10 secondes.

Une couche de métallisation 112, par exemple à base d'aluminium, est ensuite réalisée sur la face arrière du substrat 102 (voir figure 2C). Cette couche de métallisation 112 peut par exemple être réalisée par sérigraphie, ou encore par photolithographie ou impression.

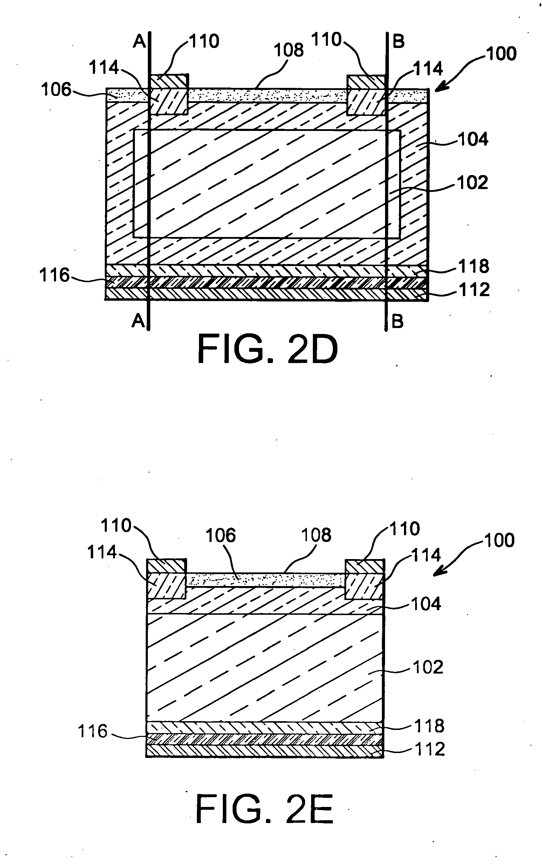

On effectue alors un deuxième recuit de la cellule photovoltaïque 100, par exemple dans un four à passage infrarouge à une température comprise entre environ 700°C et 800°C (voir figure 2D). Ce second recuit permet une meilleure passivation des défauts et des impuretés du substrat 102 car cette gamme de températures est plus favorable à la formation de liaisons entre l'hydrogène et les impuretés ou les défauts cristallographiques que la gamme de température du premier recuit (comprise entre environ 800°C et 900°C), permettant la dissociation des molécules H₂ formées par la migration des ions hydrogène issus de la couche antireflet 106 dans le substrat 102 et/ou implantés dans le substrat 102 par une étape d'hydrogénation du substrat 102. Cette température de second recuit comprise entre environ 700°C et 800°C constitue un compromis idéal entre l'intensité de la diffusion des ions hydrogène et leur capacité à former des liaisons avec les impuretés ou les défauts dans le substrat 102. Ce second recuit peut également être réalisé dans un four de recuit classique, ou par d'autres techniques de recuit connues.

Ce second recuit entraîne la formation d'une couche dopée P+ 118 dans le substrat 102 et la formation d'une couche 116 à base d'un alliage d'aluminium et de silicium, venant remplacer la couche N+ 104 sous la métallisation arrière 112. Pour les substrats de type P, la couche dopée P+ 118 réalise la passivation de la face arrière du substrat 102 par un effet de champ arrière (BSF) repoussant des porteurs minoritaires dans le substrat 102. Un métal autre que l'aluminium peut également être utilisé pour la réalisation de la couche de métallisation 112. Ce métal sera choisi pour pouvoir obtenir également une couche dopée P+ 118. Ce second recuit peut également être optimisé en choisissant une température de recuit égale à environ 770°C pendant une durée comprise entre environ 1 seconde et 10 secondes, permettant notamment d'obtenir une bonne hydrogénation du substrat 102.

Enfin, comme représenté sur la figure 2E, on supprime les portions de la couche N+ 104 reliant la couche 118 et les contacts 114, c'est-à-dire reliant électriquement les métallisations 110 de la face avant à la couche de métallisation 112 de la face arrière. Sur la figure 2E, tous les éléments de la cellule photovoltaïque 100 se trouvant du côté extérieur des plans AA et BB sont supprimés, par exemple par laser, plasma, enrobage, ou tout autre moyen de gravure.

Le procédé selon l'invention convient également particulièrement à la réalisation de cellules photovoltaïques comportant des substrats de type N. Dans ce cas, la couche dopée P+ 118 joue le rôle d'émetteur de la jonction PN de la cellule photovoltaïque. La couche dopée N+ 104 réalise alors la passivation de la face avant du substrat 102 par un effet de champ avant (FSF) repoussant des porteurs minoritaires dans le substrat 102, la couche antireflet 106 contribuant également à cette passivation. Il est également possible que la couche dopée du second type de conductivité 104 soit une couche dopée P+, obtenue par exemple par diffusion de bore dans le substrat 102.

Selon une variante, il est possible que la cellule photovoltaïque subisse un troisième recuit à basse température, par exemple comprise entre environ 200°C et 500°C. Ce troisième recuit, pouvant être réalisé à pression ambiante, permet à l'hydrogène présent dans le substrat 102 de former des liaisons supplémentaires avec des défauts cristallographiques ou des impuretés présents dans le substrat 102.

## Revendications

1. Procédé de métallisation d'au moins une cellule photovoltaïque (100) comportant un substrat (102) à base de semi-conducteur d'un premier type de conductivité, une couche (104) dopée d'un second type de conductivité réalisée dans le substrat (102) et formant une face avant du substrat (102), une couche (106) antireflet réalisée sur la face avant du substrat (102) et formant une face avant (108) de la cellule photovoltaïque (100), ledit procédé comportant au moins les étapes de :
a) réalisation d'au moins une métallisation (110) sur la face avant (108) de la cellule photovoltaïque (100),
b) premier recuit de la cellule photovoltaïque (100) à une température comprise entre environ 800°C et 900°C,
c) réalisation d'au moins une métallisation (112) sur une face arrière du substrat (102),
d) second recuit de la cellule photovoltaïque (100) à une température comprise entre environ 700°C et 800°C.

2. Procédé selon la revendication 1, la couche antireflet (106) étant riche en hydrogène.

3. Procédé selon l'une des revendications précédentes, comportant en outre au moins une étape d'hydrogénation du substrat (102).

4. Procédé selon l'une des revendications précédentes, comportant en outre, après l'étape d), une étape d'un troisième recuit de la cellule photovoltaïque (100) à une température comprise entre environ 200°C et 500°C.

5. Procédé selon l'une des revendications précédentes, la couche (104) dopée du second type de conductivité étant une couche dopée N+.

6. Procédé selon l'une des revendications précédentes, la couche antireflet (106) étant à base de nitrure de silicium.

7. Procédé selon l'une des revendications précédentes, le substrat (102) étant un substrat à base de silicium multicristallin.

8. Procédé selon l'une des revendications précédentes, la métallisation (110) réalisée sur la face avant (108) de la cellule photovoltaïque (100) étant à base d'argent.

9. Procédé selon l'une des revendications précédentes, la métallisation (112) réalisée sur la face arrière du substrat (102) étant à base d'aluminium.

10. Procédé selon l'une des revendications précédentes, la métallisation (110) en face avant et/ou la métallisation (112) en face arrière étant réalisées par sérigraphie.

11. Procédé selon l'une des revendications précédentes, le premier et/ou le second recuits étant réalisés dans un four à passage infrarouge.

12. Procédé de réalisation d'au moins une cellule photovoltaïque (100), comportant au moins les étapes de :
- texturation des surfaces d'un substrat (102) à base de semi-conducteur d'un premier type de conductivité,
- formation d'une couche (104) dopée d'un second type de conductivité dans le substrat (102) formant une face avant du substrat (102),
- dépôt d'une couche (106) antireflet sur la face avant du substrat (102), ladite couche (106) formant une face avant (108) de la cellule photovoltaïque (100),
- mise en oeuvre d'un procédé de métallisation selon l'une des revendications 1 à 11,
- suppression d'au moins une partie de la couche (104) dopée du second type de conductivité reliant électriquement la métallisation (110) de la face avant (108) à la métallisation (112) de la face arrière de la cellule photovoltaïque (100).

13. Procédé selon la revendication 12, l'étape de texturation étant réalisée avec une solution à base d'hydroxyde de potassium.

14. Procédé selon l'une des revendications 12 ou 13, la couche dopée d'un second type de conductivité (104) étant une couche dopée N+ formée par diffusion de phosphore dans le substrat (102).

15. Procédé selon l'une des revendications 12 à 14, la couche antireflet (106) étant une couche à base de nitrure de silicium déposée par PECVD.

16. Procédé selon l'une des revendications 12 à 15, comportant en outre au moins une étape d'hydrogénation du substrat (102) mise en oeuvre avant et/ou après l'étape de dépôt de la couche antireflet (106).

## Claims

1. Method for metallization of at least one photovoltaic cell (100) comprising a substrate (102) based on a semiconductor with a first type of conductivity, a layer (104) doped with a second type of conductivity produced in the substrate (102) and forming a front face of the substrate (102), an antireflection layer (106) produced on the front face of the substrate (102) and forming a front face (108) of the photovoltaic cell (100), which method is comprising at least the steps of:
a) producing at least one metallization (110) on the front face (108) of the photovoltaic cell (100),
b) a first annealing of the photovoltaic cell (100) at a temperature between around 800°C and 900°C,
c) producing at least one metallization (112) on the rear face of the substrate (102),
d) a second annealing of the photovoltaic cell (100) at a temperature between around 700°C and 800°C.

2. Method according to claim 1, the antireflection layer (106) being rich in hydrogen.

3. Method according to one of the previous claims, also comprising at least one step of hydrogenation of the substrate (102).

4. Method according to one of the previous claims, also comprising, after step d), a step of a third annealing of the photovoltaic cell (100) at a temperature between around 200°C and 500°C.

5. Method according to one of the previous claims, the layer (104) doped with the second type of conductivity being an N+ doped layer.

6. Method according to one of the previous claims, the antireflection layer (106) being based on silicon nitride.

7. Method according to one of the previous claims, the substrate (102) being a substrate based on multicrystalline silicon.

8. Method according to one of the previous claims, the metallization (110) produced on the front face (108) of the photovoltaic cell (100) being based on silver.

9. Method according to one of the previous claims, the metallization (112) produced on the rear face of the substrate (102) being based on aluminium.

10. Method according to one of the previous claims, the metallization (110) on the front face and/or the metallization (112) on the rear face being performed by serigraphy.

11. Method according to one of the previous claims, the first and/or the second annealing operation being performed in an infrared passage furnace.

12. Method for producing at least one photovoltaic cell (100), comprising at least the steps of:
- texturising the surfaces of a substrate (102) based on a semiconductor with a first type of conductivity,
- forming a layer (104) doped with a second type of conductivity in the substrate (102) forming a front face of the substrate (102),
- depositing an antireflection layer (106) on the front face of the substrate (102), which layer (106) forming a front face (108) of the photovoltaic cell (100),
- implementing a method for metallization according to one of claims 1 to 11,
- removing at least a portion of the layer (104) doped with the second type of conductivity electrically connecting the metallization (110) of the front face (108) to the metallization (112) of the rear face of the photovoltaic cell (100).

13. Method according to claim 12, the texturisation step being performed with a potassium hydroxide-based solution.

14. Method according to one of claims 12 or 13, the layer doped with a second type of conductivity (104) being an N+ layer formed by the diffusion of phosphorus in the substrate (102).

15. Method according to one of claims 12 to 14, the antireflection layer (106) being a silicon nitride-based layer deposited by PECVD.

16. Method according to one of claims 12 to 15, also comprising a step of hydrogenation of the substrate (102) implemented before and/or after the step of deposition of the antireflection layer (106).

## Patentansprüche

1. Verfahren zur Metallisierung von wenigstens einer Photovoltaikzelle (100), umfassend: ein Substrat (102) auf Basis eines Halbleiters eines ersten Leitfähigkeitstyps, eine dotierte Schicht (104) eines zweiten Leitfähiglceitstyps, in dem Substrat (102) realisiert und eine Vorderseite des Substrats (102) bildend, eine Antireflexschicht (106), auf der Vorderseite des Substrats (102) realisiert und eine Vorderseite (108) der Photovoltaikzelle (100) bildend, wobei das genannte Verfahren wenigstens die folgenden Schritte umfasst:
a) Realisierung von wenigstens einer Metallisierung (110) auf der Vorderseite (108) der Photovoltaikzelle (100),
b) erstes Glühen der Photovoltaikzelle (100) bei einer zwischen ungefähr 800°C und 900°C enthaltenen Temperatur,
c) Realisierung von wenigstens einer Metallisierung (112) auf einer Rückseite des Substrats (102),
d) zweites Glühen der Photovoltaikzelle (100) bei einer zwischen ungefähr 700°C und 800°C enthaltenen Temperatur.

2. Verfahren nach Anspruch 1, bei dem die Antireflexschicht (106) stark wasserstoffhaltig ist.

3. Verfahren nach einem der vorangehenden Ansprüche mit außerdem wenigstens einem Schritt zur Hydrierung des Substrats (102).

4. Verfahren nach einem der vorangehenden Ansprüche, mit außerdem - nach dem Schritt d) - einem dritten Schritt zum Tempern bzw. Glühen der Photovoltaikzelle (100) bei einer zwischen ungefähr 200°C und 500°C enthaltenen Temperatur.

5. Verfahren nach einem der vorangehenden Ansprüche, wobei die dotierte Schicht des zweiten Leitfähigkeitstyps eine N⁺-dotierte Schicht ist.

6. Verfahren nach einem der vorangehenden Ansprüche, wobei die Antireflexschicht (106) auf Siliciumnitrat basiert.

7. Verfahren nach einem der vorangehenden Ansprüche, bei dem das Substrat (102) ein Substrat auf Basis von multikristallinem Silizium ist.

8. Verfahren nach einem der vorangehenden Ansprüche, bei dem die auf der Vorderseite (108) hergestellte Metallisierung (110) der Photovoltaikzelle (100) auf Silber basiert.

9. Verfahren nach einem der vorangehenden Ansprüche, bei dem die auf der Rückseite des Substrats (102) hergestellte Metallisierung (112) auf Aluminium basiert.

10. Verfahren nach einem der vorangehenden Ansprüche, bei dem die Metallisierung (110) auf der Vorderseite und/oder die Metallisierung (112) auf der Rückseite durch Siebdruck hergestellt wird.

11. Verfahren nach einem der vorangehenden Ansprüche, bei dem das erste und/oder zweite Tempern bzw. Glühen in einem Infrarot-Durchlaufofen stattfindet.

12. Verfahren zur Realisierung von wenigstens einer Photovoltaikzelle (100), wenigstens folgende Schritte umfassend:
- Texturierung der Oberflächen eines Substrats (102) auf Basis eines Halbleiters eines ersten Leitfähigkeitstyps,
- Realisierung einer eine Vorderseite des Substrats (102) bildenden dotierten Schicht (104) eines zweiten Leitfähigkeitstyps in dem Substrat (102),
- Abscheidung einer Antireflexschicht (106) auf der Vorderseite des Substrats (102), wobei die genannte Schicht (106) eine Vorderseite (108) der Photovoltaikzelle (100) bildet,
- Durchführung eines Metallisierungsverfahrens nach einem der Ansprüche 1 bis 11,
- Eliminierung wenigstens eines Teils der dotierten Schicht (104) des zweiten Leitfähigkeitstyps, die die Metallisierung (110) der Vorderseite (108) elektrisch mit der Metallisierung (112) der Rückseite der Photovoltaikzelle (100) verbindet.

13. Verfahren nach Anspruch 12, wobei der Texturierungsschritt mit einer Lösung auf Kaliumhydroxid-Basis realisiert wird.

14. Verfahren nach einem der Ansprüche 12 oder 13, wobei die dotierte Schicht eines zweiten Leitfähigkeitstyps (104) eine N⁺-dotierte Schicht ist, erzeugt durch Phosphordiffusion in dem Substrat (102).

15. Verfahren nach einem der Ansprüche 12 bis 14, wobei die Antireflexschicht (106) eine Schicht auf der Basis von Siliciumnitrid ist, abgeschieden mittels PECVD.

16. Verfahren nach einem der Ansprüche 12 bis 15, außerdem wenigstens einen Hydrierungsschritt des Substrats (102) umfassend, durchgeführt vor und/oder nach dem Schritt zur Abscheidung der Antireflexschicht (106).
